# EUROPÄISCHE PATENTSCHRIFT

(11) **EP 2 892 660 B1**
(45) Veröffentlichungstag und Bekanntmachung des Hinweises auf die Patenterteilung: **02.11.2022**
(21) Anmeldenummer: 13762428.4
(22) Anmeldetag: 09.09.2013
(51) Int. Cl.: B06B 1/02, B23K 20/10, G01R 31/28

(54) **VERFAHREN UND SCHALTUNGSSYSTEM ZUM BESTIMMEN EINES ARBEITSBEREICHS EINES ULTRASCHALL-SCHWINGGEBILDES**
METHOD AND CIRCUIT SYSTEM FOR DETERMINING A WORKING RANGE OF AN ULTRASONIC VIBRATING UNIT
PROCÉDÉ ET SYSTÈME DE CIRCUIT PERMETTANT DE DÉTERMINER UNE ZONE DE TRAVAIL D'UN ENSEMBLE CONVERTISSEUR/BOOSTER/SONOTRODE À ULTRASONS

(30) Priorität: 10.09.2012 DE 102012215994
(43) Veröffentlichungstag der Anmeldung: 15.07.2015
(73) Patentinhaber: Weber Ultrasonics AG, 76307 Karlsbad-Ittersbach (DE)
(72) Erfinder: BRÜHN, Xenia, 76228 Karlsruhe (DE); BROSZEIT, Ralf, 75181 Pforzheim (DE)
(74) Vertreter: LBP Lemcke, Brommer & Partner Patentanwälte mbB
(86) Internationale Anmeldenummer: PCT/EP2013/068556
(87) Internationale Veröffentlichungsnummer: WO 2014/037550

(56) Entgegenhaltungen:
- EP-A2- 1 369 185
- US-A- 4 849 872
- US-A- 4 879 528
- US-A- 4 973 876
- US-A- 5 425 704
- US-A- 5 892 315
- US-A1- 2010 102 672

## Beschreibung

Die Erfindung betrifft ein Verfahren nach dem Oberbegriff des Anspruchs 1 zum Bestimmen eines Arbeitsbereiches eines Ultraschall-Schwinggebildes.

Weiterhin betrifft die Erfindung ein Schaltungssystem nach dem Oberbegriff des Anspruchs 8.

Ultraschall-Schwinggebilde (auch als Ultraschall-Schwingsysteme bezeichnet) finden nicht nur im Bereich der Reinigung mit Ultraschall, sondern auch in anderen Bereichen der Technik, wie z.B. dem Schweißen oder Schneiden mittels Ultraschall Anwendung. Neben einem Ultraschall-Generator, der die Schwingungen durch Anregung mittels eines hochfrequenten elektrischen Signals induziert, ist ein Schwinggebilde notwendig, das einen Ultraschallwandler (z.B. einen Piezowandler) umfasst bzw. mit einem solchen zusammenwirkt, welcher Ultraschallwandler elektrische Schwingungen in mechanische Schwingungen umwandelt. Außerdem umfasst das Schwinggebilde noch den eigentlichen Ultraschallschwinger oder -Strahler oder eine Sonotrode, welcher bzw. welche die eigentlichen Ultraschallschwingungen an ein Medium oder ein Werkstück abgibt. Schwinggebilde bzw. Ultraschallwandler einerseits sowie der Ultraschall-Generator mit seinem elektrischen Anpassnetzwerk andererseits bilden zusammen einen elektromagnetischen Schwingkreis. Je nach Anwendungsgebiet können die Schwinggebilde in unterschiedlichen geometrischen Formen und Größen sowie verschiedenen Materialien ausgestaltet sein, wobei sie aufgrund ihrer Form und Zusammensetzung sowie der damit einhergehenden veränderten Eigenschaften des genannten Schwingkreises unterschiedliche Arbeitsbereiche besitzen, was die erforderliche optimale Anregungsfrequenz anbelangt. Die genannten Arbeitsbereiche lassen sich im Frequenzraum durch Resonanzpunkte (Resonanzfrequenzen) im Schwingungsverhalten, der sogenannten Parallel- und Reihenresonanz, definieren bzw. begrenzen. Bei Kenntnis der Resonanzpunkte im Zusammenspiel von Generator und Schwinggebilde ist der optimale Arbeitsbereich eines damit ausgestatteten Ultraschallgeräts bestimmbar.

Ist es notwendig, das Schwinggebilde zu wechseln, hat ein neues Schwinggebilde bzw. der entsprechende Schwingkreis in der Regel nicht die gleiche Startfrequenz bzw. den gleichen Arbeitsbereich wie das zuvor verwendete Schwinggebilde. Unter "Startfrequenz" wird diejenige Erregungsfrequenz des Generators verstanden, mit welcher das Schwinggebilde beim Inbetriebnehmen eines entsprechenden Ultraschallgeräts anfänglich angeregt wird. Die Startfrequenz insbesondere sollte derart ausgewählt sein, dass das Gerät bzw. das Schwinggebilde nicht beschädigt wird. Auch Veränderungen von äußeren Parametern, z. B. große Temperaturschwankungen, haben eine Verschiebung von Resonanzpunkten des Schwinggebildes bzw. des gesamten Schwingkreises zur Folge. Ohne Kenntnisstand der Resonanzpunkte ist der Arbeitsbereich der gesamten Apparatur nicht bekannt.

Demnach muss bei einem Wechsel bzw. den genannten Veränderungen zumeist die Startfrequenz neu ermittelt und der Arbeitsbereich entsprechend neu eingestellt werden. Hierzu sind entsprechende Messwerkzeuge, wie Impedanzanalysierer, notwendig, die jedoch teuer und aufwändig zu bedienen sind. Das Ultraschall-Schwinggebilde kann jedoch ohne entsprechende Einstellung nicht ordnungsgemäß verwendet werden.

Eine aus dem Stand der Technik bekannte Möglichkeit, die Resonanzpunkte vor Ort zu bestimmen und weiterhin einen korrekten Betrieb des Schwinggebildes zu gewährleisten, besteht darin, die Resonanzpunkte mittels eines Frequenzdurchlaufes eines Frequenzbereichs (Scan) unter Schallabgabe im Leerlauf, d.h. mit freischwingendem Schwinggebilde ohne Medium bzw. Druck und entsprechend ohne Bedämpfung zu ermitteln. Das Schwinggebilde wird dazu bei niedriger Generatorleistung mit einem pulsweitenmodulierten Signal beaufschlagt, wobei ein bestimmter Frequenzbereich im Leerlauf durchlaufen wird. Durch Analyse der Leistung, der Phase sowie des Stromdurchganges werden die Resonanzpunkte ermittelt, um den Arbeitsbereich festzulegen. Jedoch bedingt die Schallabgabe im Leerlauf zum einen eine sehr hohe Lautstärke, zum anderen kann das Schwinggebilde durch eine Anregung mit zu hoher Leistung beschädigt und infolgedessen funktionsuntüchtig werden. Auch eine Gefährdung des Bedienpersonals ist nicht ausgeschlossen.

Die zuvor beschriebene Möglichkeit zur Bestimmung der Resonanzpunkte eines Schwinggebildes wird beispielsweise in den Druckschriften US 4 849 872 A, US 4 879 528 A, US 5 892 315 A und US 2010/102672 A1 offenbart.

Speziell die US 4 879 528 A offenbart in diesem Zusammenhang in der dortigen Figur 8 eine Schaltungsanordnung mit einem Ultraschall-Schwingelement, das durch das Ausgangssignal eines spannungsgesteuerten Oszillators über einen FET und einen Anpassungstransformator erregt wird. Um die Phasendifferenz zwischen der Spannung und dem Strom des Ansteuersignals für das Ultraschall-Schwingelement zu erfassen, wird - während das Ansteuersignal für das Ultraschall-Schwingelement anliegt - ein Stromdetektor an die Sekundärseite des Anpassungstransformators angeschlossen, um die Spannung abzuleiten, deren Phase der des Ansteuerstroms entspricht. Dies bringt die weiter oben angesprochenen Nachteile mit sich.

Der Erfindung liegt daher die Aufgabe zu Grunde, den Arbeitsbereich eines Schwinggebildes unter Vermeidung der vorgenannten Nachteile schnell und einfach bestimmen zu können.

Die Aufgabe wird erfindungsgemäß durch ein Verfahren mit den Merkmalen des Anspruchs 1 gelöst. Ferner wird die Aufgabe durch ein Schaltungssystem mit den Merkmalen des Anspruchs 8 gelöst. Vorteilhafte Weiterbildungen sind jeweils Gegenstand von Unteransprüchen.

Erfindungsgemäß ist ein Verfahren zum Bestimmen eines Arbeitsbereiches eines Ultraschall-Schwinggebildes, welches Ultraschall-Schwinggebilde von einem Generator über einen Ausgang mit elektrischer Energie versorgt und zu Ultraschallschwingungen angeregt wird, wobei zumindest Bestandteile des Ultraschall-Schwinggebildes, vorzugsweise ein darin enthaltener Ultraschallwandler, und Bestandteile des Generators, vorzugsweise ein ausgangsseitiges Anpassnetzwerk, einen Schwingkreis bilden, und wobei dem Ausgang des Generators eine Messschaltung und eine Endstufe vorgeschaltet sind, welche Endstufe zur Anlegung von Signalen an den Schwingkreis zur Anregung des Ultraschall-Schwinggebildes ausgebildet ist, und mittels welcher Messschaltung zumindest die Phase, vorzugsweise Phase und Betrag, einer Impedanz des Schwingkreises gemessen werden, und zumindest die Phase, vorzugsweise Phase und Betrag, der Impedanz zum Bestimmen des Arbeitsbereichs ausgewertet wird, indem über die Messschaltung eine Spannung an den Schwingkreis angelegt wird, dadurch gekennzeichnet, dass während des Anlegens der Spannung über die Messschaltung an den Schwingkreis keine Spannung über die Endstufe an den Schwingkreis angelegt wird.

Die Impedanz ist der Quotient aus komplexer Wechselspannung und komplexen Wechselstrom und beinhaltet für den Fachmann die Zusammenfassung von zwei Aussagen: Sie gibt das Verhältnis der Amplitude von sinusförmiger Wechselspannung zu sinusförmigem Wechselstrom an, und sie gibt die Phasenverschiebung zwischen diesen beiden Größen an. Letztere wird vorliegend als "Phase der Impedanz" bezeichnet.

Erfindungsgemäß ist ein Schaltungssystem, umfassend eine Schaltungsanordnung zur Durchführung eines erfindungsgemäßen Verfahrens und einen Generator, welche Schaltungsanordnung ein Ultraschall-Schwinggebilde umfasst, welches Ultraschall-Schwinggebilde an den Generator angeschlossen ist und von dem Generator über einen Ausgang mit elektrischer Energie versorgbar und zu Ultraschallschwingungen anregbar ist, wobei zumindest Bestandteile des Ultraschall-Schwinggebildes, vorzugsweise ein darin enthaltener Ultraschallwandler, und Bestandteile des Generators, vorzugsweise ein ausgangsseitiges Anpassnetzwerk, einen Schwingkreis bilden, und wobei dem Ausgang des Generators eine Messschaltung und eine Endstufe vorgeschaltet sind, welche Endstufe zur Anlegung von Signalen an den Schwingkreis zur Anregung des Ultraschall-Schwinggebildes ausgebildet ist, und wobei mittels der Messschaltung die Phase, vorzugsweise Phase und Betrag, einer Impedanz des Schwingkreises messbar ist, und wobei die Schaltungsanordnung weiterhin dazu ausgebildet ist, zumindest die Phase, vorzugsweise Phase und Betrag, der Impedanz zwecks Bestimmung des Arbeitsbereichs auszuwerten, wobei über die Messschaltung eine Spannung an den Schwingkreis anlegbar ist, dadurch gekennzeichnet, dass die Schaltungsanordnung dazu ausgebildet ist, während des Anlegens der Spannung über die Messschaltung an den Schwingkreis keine Spannung über die Endstufe an den Schwingkreis anzulegen.

Im Kontext der vorliegenden Beschreibung bilden der in dem Ultraschall-Schwinggebilde enthaltene Ultraschallwandler und das ausgangsseitige Anpassnetzwerk des Generators einen elektrischen Schwingkreis. Wenn man zusätzlich noch den eigentlichen Ultraschallschwinger oder -Strahler mit berücksichtigt, der das Verhalten des genannten Schwingkreises beeinflusst, ergibt sich ein erweiterter elektromechanischer Schwingkreis. Beide Begriffe werden im Zuge dieser Beschreibung synonym verwendet und zu "Schwingkreis" verallgemeinert.

Über die genannte Messschaltung kann erfindungsgemäß im Rahmen einer Art "Vorab-Scan" der optimale Arbeitsbereich des Ultraschall-Schwinggebildes ermittelt und für den späteren Betrieb steuerungstechnisch ausgenutzt werden, ohne dass zu diesem Zweck das Schwinggebilde selbst "im Leerlauf" substantiell zu Schwingungen angeregt werden müsste.

Die Erfindung sieht im Zuge einer ersten Weiterbildung vor, dass die Messschaltung mit einem Transformator innerhalb des Generators verbunden ist. Dabei kann die Messschaltung innerhalb des Generators selbst angeordnet sein. Es kann jedoch alternativ auch vorgesehen sein, dass die Messschaltung außerhalb des Generators angeordnet ist, um eine mobile Messstation zu realisieren. Besonders bevorzugt ist vorgesehen, dass der Transformator primärseitig oder sekundärseitig eine induktive Ankopplung aufweist, vorzugsweise eine primärseitige Hilfswicklung, die schaltungstechnisch zwischen Schwingkreis und Messschaltung angeordnet ist, um die oben erwähnten Messungen an dem Schwingkreis durchführen zu können. Höchst vorzugsweise besitzt der Transformator primärseitig zusätzlich zu einer Primärwicklung für die Endstufe (Ansteuerung) für das eigentliche HF-Anregungssignal eine Hilfswicklung, die zwischen Schwingkreis und Messschaltung angeordnet ist und die mit diesen in elektrotechnischer Wirkverbindung steht. Vorteilhafter Weise sind die Messschaltung primärseitig und der Schwingkreis sekundärseitig bezüglich des Transformators angeordnet.

Die Erfindung ist jedoch keinesfalls auf eine induktive Ankopplung an dem genannten Transformator beschränkt. Vielmehr sieht eine andere Weiterbildung der Erfindung vor, dass die Spannung über eine induktive Ankopplung an einem weiteren Bauteil, insbesondere einer Induktivität oder Drossel (Spule), innerhalb des Generators oder in elektrischer Wirkverbindung mit dem Generator angelegt wird. Betreffend eine erfindungsgemäße Schaltungsanordnung kann entsprechend vorgesehen sein, dass die Messschaltung mit einem induktiven Bauteil innerhalb des Generators oder in elektrischer Wirkverbindung mit dem Generator verbunden ist, vorzugsweise induktiv angekoppelt. Unter "induktiv angekoppelt" wird in diesem Zusammenhang eine elektromagnetische Wirkverbindung durch Ausnutzung induktiver Eigenschaften der entsprechenden Bauteile verstanden, was dem Fachmann an sich geläufig ist.

Bevorzugt - jedoch ohne Beschränkung - kann die Messschaltung mit Operationsverstärkern oder Impedanzkonvertern aufgebaut werden, worauf weiter unten noch genauer eingegangen wird. Der Aufbau der erfindungsgemäßen Schaltungsanordnung ist mit einem nur geringen schaltungstechnischen Aufwand verbunden, zumal der angesprochene Transformator bei handelsüblichen Ultraschall-Generatoren stets vorhanden ist.

Zur Aufnahme und Auswertung der auftretenden Signale ist bevorzugt vorgesehen, dass dem Schwingkreis eine Signalverarbeitungseinheit zum Auslesen von Signalverläufen von Betrag und Phase der Impedanz des Schwingkreises in Abhängigkeit von der Frequenz und/oder eine Datenverarbeitungseinheit zur Auswertung der gemessenen Signalverläufe zugeordnet ist. Die Signalverarbeitungseinheit kann weiterhin zum Erzeugen einer der Phase der Impedanz proportionalen Gleichspannung ausgebildet sein. Die Datenverarbeitungseinheit ist vorzugsweise dazu eingerichtet, anhand der gemessenen Signalverläufe den Arbeitsbereich automatisch zu erkennen und/oder anzuzeigen. Sowohl die Signalverarbeitungseinheit als auch die Datenverarbeitungseinheit kann bzw. können innerhalb des Generators selbst angeordnet oder ausgebildet sein. Auch eine externe Anordnung dieser Einheiten ist möglich, um eine mobile Auswertung zu ermöglichen, wobei ein Abgriff der zu verarbeitenden bzw. auszuwertenden Signale an einem entsprechenden Signalausgang des Generators erfolgen kann. Eine Möglichkeit der Auswertung ist die Verwendung eines handelsüblichen Oszilloskops.

Besonders bevorzugt sieht die Erfindung zur Anregung des Schwingkreises vor, dass die Spannung über eine induktive, primärseitige oder sekundärseitige Ankopplung an einen Transformator innerhalb des Generators an den Schwingkreis angelegt wird, vorzugsweise über eine primärseitigen Hilfswicklung des Generators. Im diesem Zusammenhang werden vorzugsweise Betrag und/oder Phase der Impedanz über die induktive Ankopplung an den Transformator, vorzugsweise die primärseitige Hilfswicklung des Transformators, gemessen. Vorzugsweise wird eine relativ kleine Spannung in der Größenordnung von 1-50 V angelegt, vorzugsweise etwa 1 bis 15 V, höchst vorzugsweise etwa 5 V. Die Spannung wird hierbei direkt über die induktive Ankopplung bzw. die Hilfswicklung an den Schwingkreis bzw. das Schwinggebilde angelegt, nicht über die Endstufe bzw. die entsprechende primärseitige Transformatorwicklung. Besonders vorteilhaft ist demnach die primärseitige Messung der Impedanz des Schwingkreises, wobei die Messung nur unter Verwendung der genannten Transformator-Hilfswicklung und vollständig ohne Beaufschlagung der Endstufe erfolgt. Infolgedessen wird das Schwinggebilde nicht - wie aus dem Stand der Technik bekannt - zum Schwingen angeregt. Die Messung verläuft daher geräuschlos und ohne jede Gefahr für Bediener und Gerät, worauf bereits hingewiesen wurde.

Die Messschaltung verfügt weiterhin vorzugsweise über einen Frequenzeingang, an welchen eine Frequenz f angelegt werden kann, bei der die Messung mittels der Messschaltung erfolgen soll. Im Zuge einer Ausgestaltung ist weiterhin bevorzugt vorgesehen, dass über die primärseitige Hilfswicklung des Transformators Betrag und Phase der Impedanz des Schwingkreises gemessen bzw. bestimmt werden. Zur Messung bzw. für eine entsprechende Signalverarbeitung und Auswertung werden vorzugsweise die gemessenen Signale an entsprechenden Signalausgängen der Messschaltung mittels einer geeignet ausgebildeten Signalverarbeitungseinheit abgegriffen. Diese kann speziell dazu ausgebildet sein, eine zur gemessenen Phase der Impedanz des Schwingkreises proportionale Gleichspannung zu Auswertezwecken zu erzeugen.

Hiernach werden die gemessenen bzw. abgegriffenen Signale vorzugsweise von der Signalverarbeitungseinheit an eine Datenverarbeitungseinheit gesendet, wobei eine Auswertung der Signale bevorzugt anhand einer zur Phase der Impedanz proportionalen Gleichspannung erfolgt, wie vorstehend erwähnt. Je nachdem, welchen Betrag und/oder welches Vorzeichen die Phase hat, kann die Datenverarbeitungseinheit erkennen, in weichem Abschnitt seines Arbeitsbereichs sich der Schwingkreis bzw. das Schwinggebilde befindet. Eine Impedanz-Phase von 0° (Spannung und Strom in Phase) weist bspw. auf einen Resonanzpunkt hin. So können bei einer Abfolge von vorgegebenen Grundfrequenzen im Verlauf eines Scans die entsprechenden Resonanzpunkte erkannt werden. Die Impedanzmessung ermöglicht es zu erkennen und zu unterscheiden, ob ein Schwinggebilde überhaupt angeschlossen ist (ohne Schwinggebilde konstante Phase mit relativ hohem Betrag) oder ob in den Zuleitungen ein Kurzschluss (Phase beträgt 0° unabhängig von der eingestellten Frequenz) aufgetreten ist. Die Anordnung ist damit zur einfachen Fehlersuche nutzbar.

Vorzugsweise erfolgt der genannte Scan als sog. schonender Vorab-Scan vor der eigentlichen Inbetriebnahme des Ultraschallgeräts.

Die Messungen der Impedanz des Schwingkreises müssen im Zuge eines entsprechenden Ausgestaltung der Erfindung nicht mit einem externen Impedanzanalysierer vorgenommen werden, sondern können mit dem vorhandenen Generator durchgeführt werden, da der genannte Transformator bei den verwendeten Ultraschallgeneratoren stets vorhanden ist und lediglich um eine Hilfswicklung auf seiner Primärseite ergänzt zu werden braucht.

Das Verfahren kann zusätzlich oder alternativ auch im Dauerbetrieb genutzt werden, um eine kontinuierliche Überwachung des Schwingkreises und damit des Schwinggebildes zu erreichen. Vorzugsweise liefert die Datenverarbeitungseinheit in diesem Zusammenhang ein entsprechendes Steuersignal an das restliche Gerät, insbesondere den Generator, um die Energieversorgung des Schwinggebildes zu stoppen oder zu begrenzen, wenn die Überwachung eine Fehlfunktion anzeigt. Beschädigungen vor oder bei Inbetriebnahme werden durch die fehlende Anregung des Schwinggebildes vermieden, und Lärmbelästigungen werden verhindert.

Weitere Einzelheiten und Merkmale der Erfindung sind aus der folgenden Beschreibung eines Ausführungsbeispiels unter Bezugnahme auf die Zeichnung ersichtlich. Es zeigen:
- Fig. 1: ein Ersatzschaltbild eines Transformators mit erfindungsgemäßer Schaltungsanordnung zur Durchführung des erfindungsgemäßen Verfahrens;
- Fig. 2: ein schematisches Funktionsschaltbild einer erfindungsgemäßen Schaltungsanordnung;
- Fig. 3: ein detailliertes Schaltbild einer möglichen Messschaltung als Teil der erfindungsgemäßen Schaltungsanordnung;
- Fig. 4: ein Ablaufdiagramm einer Ausgestaltung des erfindungsgemäßen Verfahrens; und
- Fig. 5-7: Beispiele für gemessene Signalverläufe bei der Auswertung von Messungen im Rahmen des erfindungsgemäßen Verfahrens.

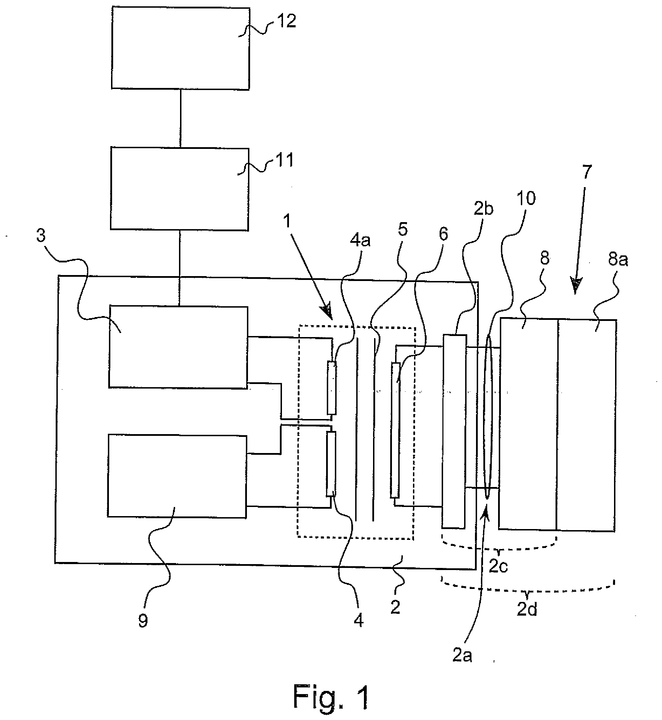

In der Fig. 1 ist das Ersatzschaltbild eines Ultraschallschwingsystems dargestellt, welches gemäß einer Ausführungsform der Erfindung einen Transformator 1 (gestrichelte Box) umfasst, der innerhalb eines (Ultraschall-)Generators 2 angeordnet ist. Der Transformator 1 ist weiterhin mit einer Messschaltung 3 verbunden. Eine primärseitige Transformatorwicklung 4 steht über einen Ferritkern 5 in Wirkverbindung mit einer Induktivität (sekundärseitige Transformatorwicklung) 6, wobei der Transformator 1 noch bei dem gezeigten Ausführungsbeispiel eine zusätzliche primärseitige Hilfswicklung 4a aufweist.

Die Induktivität 6 auf der Sekundärseite des Transformators 1 ist elektrisch mit einem Ultraschall-Wandler 8 verbunden, welcher mittels eines Kabels 10 an einem Ausgang 2a des Generators 2 angeschlossen ist und zusammen mit der Induktivität 6 und einem regelmäßig vorhandenen Anpassnetzwerk 2b des Generators 2 einen elektrischen Schwingkreis 2c bildet. Der Ultraschallwandler 8, z.B. ein Piezowandler, wandelt elektrische Energie aus dem Generator 2 in mechanische Energie um. Ihm nachgeschaltet ist der eigentliche Ultraschallschwinger 8a, wobei Ultraschallwandler 8 und Ultraschallschwinger 8a ein Ultraschall-Schwinggebilde 7 bilden, sodass der Ultraschallschwinger 8a, beispielsweise ein Ultraschall-Schneidmesser, mittels des Ultraschallwandlers 8 zu mechanischen Schwingungen anregbar ist. Die Komponenten 2b, 8 des elektrischen Schwingkreises 2c bilden zusammen mit dem Ultraschallschwinger 8a einen erweiterten elektromechanischen Schwingkreis, der in Fig. 1 mit dem Bezugszeichen 2d bezeichnet ist. Elektrische Energie ist mittels des Transformators 1 bzw. des Generators 2 an den Schwingkreis 2c, 2d leitbar, wobei im regulären Betrieb eine Verstärkung der elektrischen Anregungssignale gewünschter Frequenz über eine Endstufe (Ansteuerung) 9 erfolgt, die über die genannte primärseitige Trafowicklung 4 (Endstufenwicklung) an den Transformator 1 angeschlossen ist.

Der Generator 2 und hierin speziell die Messschaltung 3 ist zum Abgriff der elektrischen Signale des Schwingkreises 2c, 2d mit einer Signalverarbeitungseinheit 11 und zur weiteren Auswertung der abgegriffenen Signale mit einer Datenverarbeitungseinheit 12 verbunden. Letztere umfasst geeignete Prozessormittel, wie in einem handelsüblichen Computer mit entsprechender Auswertungssoftware, oder auch ein Oszilloskop. Signalverarbeitungseinheit 11 und Datenverarbeitungseinheit 12 sind bei der gezeigten Ausführungsform außerhalb des Generators 2 angeordnet.

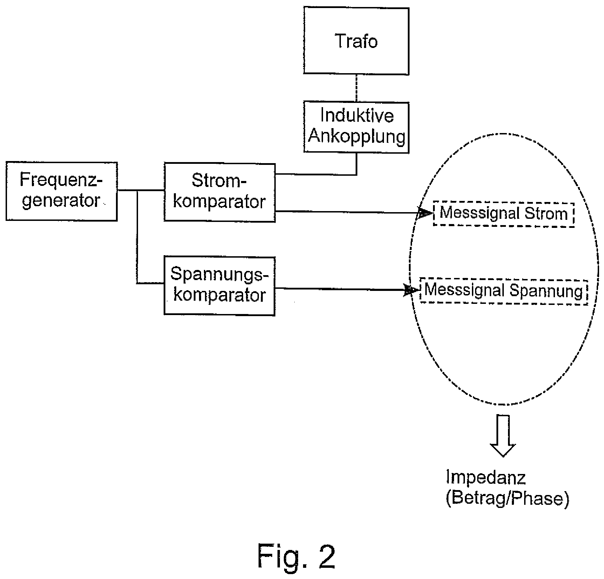

Es sei an dieser Stelle angemerkt, dass die Erfindung grundsätzlich nicht darauf beschränkt ist, die Messschaltung 3 über eine primärseitige Hilfswicklung an den Transformator 1 anzukoppeln. Alternativ kann auch eine sekundärseitige Hilfswicklung Verwendung finden, oder es kann allgemein eine induktive Ankopplung der Messschaltung an den Transformator oder an ein anderes induktiv wirksames Bauteil (nicht gezeigt) realisiert sein, vgl. Figur 2.

Die Fig. 2 zeigt ein grundlegendes Funktionsschaltbild einer im Rahmen der Erfindung einsetzbaren Messschaltung. Dargestellt ist der bereits erwähnte Transformator ("Trafo"), an den die restliche Messschaltung induktiv angekoppelt ist. Die Schaltung umfasst einen beliebig ausgebildeten Stromkomparator und einen ebensolchen Spannungskomparator, die mit einem Frequenzgenerator verbunden sind. Der Stromkomparator liefert ein Strom-Messsignal, und der Spannungskomparator liefert ein Spannungs-Messsignal. Beide Messsignale werden einer Auswertung zugeführt, um Phase und/oder Betrag der Impedanz des an den Transformator angekoppelten Schwingkreises (vgl. Fig. 1) zu bestimmen.

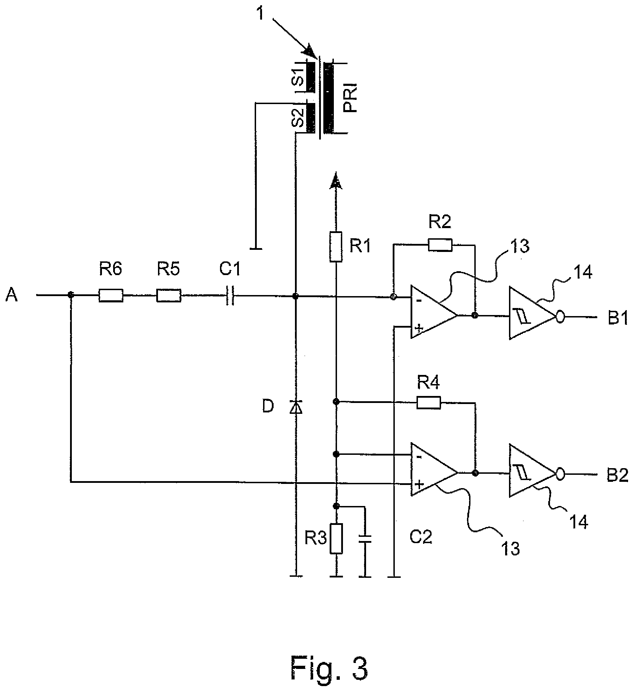

In der Fig. 3 ist ein Detailschaltbild einer Messschaltung 3 als Teil einer erfindungsgemäßen Schaltungsanordnung dargestellt, mit welcher sich das Konzept gemäß Fig. 2 umsetzen lässt. Die Figur zeigt eine beispielhafte Schaltung, die mit Hilfe von Operationsverstärkern aufgebaut ist. Es ist ein Signaleingang A vorgesehen, über den an die Messschaltung 3 eine bestimmte Frequenz anlegbar ist (vgl. "Frequenzgenerator" in Fig. 2), bei welcher die Messung am Schwingkreis durchgeführt werden soll. Im Zuge eines (Vorab-)Scans kann diese Frequenz insbesondere kontinuierlich variiert werden. Die Messschaltung 3 weist weiterhin eine Anzahl von Widerständen auf, die in der Fig. 3 mit R1 bis R6 bezeichnet sind. Auch sind eine Diode D und Kapazitäten C1, C2 vorgesehen. Über einen Knoten K ist die Messschaltung 3 an die primärseitige Trafo-Hilfswicklung 4a (vgl. Fig. 1) angeschlossen und so mit der restlichen Schaltungsanordnung bzw. dem Schwingkreis signaltechnisch verbunden. Im Schaltbild gemäß Fig. 3 sind weiterhin zwei Operationsverstärker 13 angeordnet, denen jeweils ein invertierter Schmitt-Trigger 14 nachgeschaltet ist, sodass sich ein sogenannter Transimpedanzwandler als Stromkomparator ergibt. Als Messsignale oder Ausgangssignale der Schaltung 3 sind über einen Ausgang B1 ein Signal entsprechend der Phase des im Schwingkreis fließenden Stroms und über einen Ausgang B2 ein Signal entsprechend der Phase der im Schwingkreis vorhandenen Spannung abgreifbar.

Wie der Fachmann leicht erkennt, ist die Erfindung keinesfalls auf die Verwendung der Schaltung gemäß Fig. 3 beschränkt. Jede Schaltung, die vergleichbare Messergebnisse liefert, kann im Rahmen der Erfindung alternativ zum Einsatz kommen. Eine beispielhafte alternative Realisierung der Schaltung 3 mit Impedanzkonvertern (z.B. AD5933 oder AD5934) ist ebenfalls möglich.

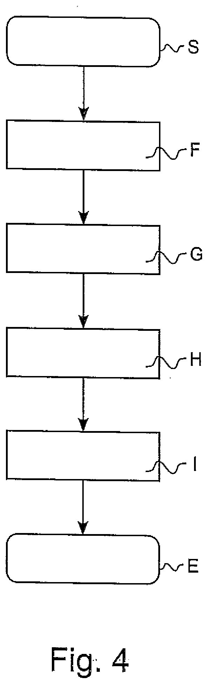

In der Fig. 4 ist ein Ablaufdiagramm eines erfindungsgemäßen Verfahrens abgebildet. Gemäß Schritt F wird nach dem Start des Verfahrens ein Mess-Anregungssignal niedriger Spannung über den Eingang A der Messschaltung 3 gemäß Fig. 3 direkt an den Schwingkreis 2c, 2d (vgl. Fig. 1), d.h. über die Hilfswicklung 4a des Transformators 1 und über die nachgeschalteten Bestandteile des Generators 2 an den Ultraschallwandler 8 gegeben. Über den Frequenzeingang A wird das Messsignal mit (vorzugsweise variabler) Frequenz f der Schaltungsanordnung zugeführt, wobei nur eine elektrische Spannung U niedrigen Betrags an die Hilfswicklung 4a angelegt wird. Die Spannung U wird aus einem Spannungswertebereich von ca. 1-50 V ausgewählt und beträgt im hier beschriebenen Ausführungsbeispiel vorzugsweise U = 5 V. Da die Spannung über die Hilfswicklung 4a an den Schwingkreis 2c, 2d gegeben wird, liegt keine Spannung an der Endstufe 9 an. Es findet somit auch keine Verstärkung eines über die Endstufe 9 an den Ultraschallwandler 8 gelieferten Anregungssignals statt. Der Schwingkreis 2c, 2d wird folglich nur auf niedrigem Niveau zwecks Impedanzmessung angeregt, ohne dass eine spürbare Wandlung elektrischer Energie in mechanische Schwingungsenergie erfolgt. Damit erfolgt auch keine merkliche Anregung des Schwinggebildes 7 als solches über den Ultraschallwandler 8.

In einem anschließenden Schritt G wird mittels der Messschaltung 3 die Impedanz des Schwingkreises gemessen, wobei am Ausgang B1 ein Messsignal für den Strom und über den Ausgang B2 ein Messsignal für die Spannung abgegriffen wird, vgl. Fig. 2.

Die genannten Signale werden dann in Schritt H mittels der Signalverarbeitungseinheit 11 aufgenommen. Die gemessenen und aufgenommenen Signalverläufe werden anschließend in Schritt I mittels der Datenverarbeitungseinheit 12 anhand einer zu der Phase der Impedanz (Phasenunterschied zwischen Strom und Spannung) proportionalen Gleichspannung ausgewertet. Zur einfachen und schnellen Auswertung kann beispielsweise ein handelsübliches Oszilloskop Verwendung finden.

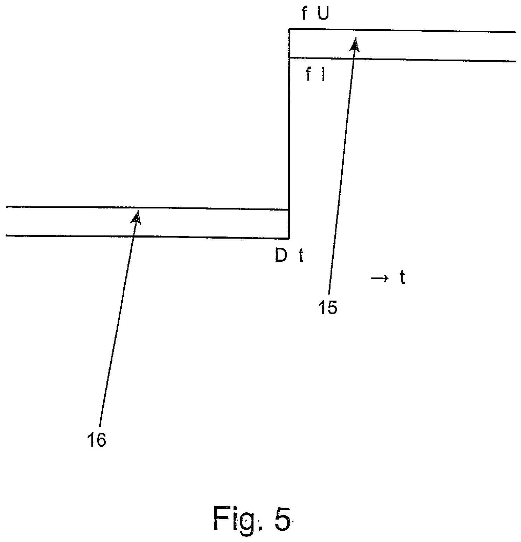

Fig. 5 bis 7 zeigen beispielhaft Auswertungen der genannten Signale bzw. Signalverläufe mittels eines Oszilloskops als Signalverarbeitungseinheit 11 und Datenverarbeitungseinheit 12.

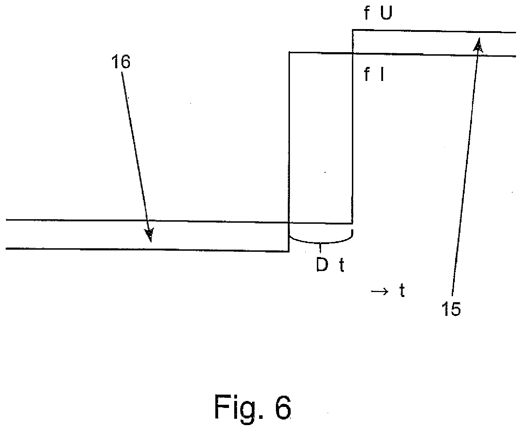

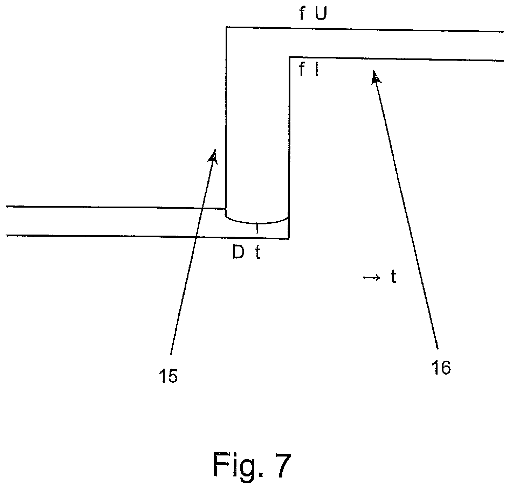

Jeweils eine erste Linie 15 gehört zu einer Auswertung des Spannungssignals, eine zweite Linie 16 zu dem Stromsignal. Zu beachten ist hierbei jeweils die relative Phasenlage zwischen den Nulldurchgängen der Signale 15, 16. Die relative Phasenlage, welche zwischen Zeitunterschied Dt entspricht, gibt darüber Aufschluss, welcher Punkt im Arbeitsbereich des Schwingsystems erreicht wurde, ob ein Kurzschluss vorliegt oder das Schwinggebilde 7 bzw. der zugehörige Ultraschallwandler 8 (vgl. Fig. 1) überhaupt angeschlossen ist. Hierzu ist auch das Vorzeichen zu betrachten. Bspw. sollte im Bereich zwischen den Resonanzpunkten der Serienresonanz und der Parallelresonanz (Arbeitsbereich) die Phase der Impedanz ein positives Vorzeichen und einen von Null verschiedenen Betrag zeigen, wobei der Strom der Spannung vorauseilt (vgl. Fig. 7). Unterhalb der Serienresonanz ist eine negative Phase mit einem Betrag ungleich Null zu erwarten. Oberhalb der Parallelresonanz sollte ebenfalls eine Phase mit negativem Vorzeichen und einem Betrag ungleich Null messbar sein (vgl. Fig. 6). Bei frequenzunabhängiger Phase von 0° ist ein Kurzschluss aufgetreten; bei einem Betrag der Phase ungleich Null und negativem Vorzeichen unabhängig von der Frequenz könnte das Schwinggebilde 7 fehlen oder falsch angeschlossen sein (sog. "offenes Ende").

Über die dargestellte Auswertung, welche bevorzugt durch die Elemente 11, 12 gemäß Fig. 1 vorgenommen wird und deren Ergebnis anschließend steuerungs- oder regelungstechnisch auf den Betrieb des Gesamtsystems gemäß Fig. 1 zurückwirken kann, lässt sich der Betrag der jeweiligen Phase (Strom, Spannung) bestimmen und daraus die Phase der Impedanz des Schwingkreises 2c, 2d (vgl. Fig. 1) ermitteln. Mittels Durchstimmen des Frequenzbereichs und jeweiligem Anlegen der erwähnten Messspannung U wird die Lage der Resonanzpunkte ermittelt, wonach der Arbeitsbereich des Schwinggebildes 7 auf schonende Weise festgelegt werden und zur Steuerung des Geräts verwendet kann.

Die Fig. 5 zeigt hierzu ein Beispiel einer Auswertung am Punkt der Parallel- oder Serienresonanz des Schwingkreises. Die Phase der Impedanz, entsprechend einem zeitlichen Unterschied Dt der Nulldurchgänge der Signale 15, 16, zeigt im Wesentlichen genau 0° an. In den Resonanzpunkten sollte der Betrag der Phase stets Null sein. Dieser Zustand tritt bei ordnungsgemäß angeschlossenem Schwingsystem über den Arbeitsbereich bzw. an dessen Rändern zwei Mal auf.

In der Fig. 6 ist beispielhaft der Fall dargestellt, dass das Spannungssignal 15 dem Stromsignal 16 vorauseilt (negative Phase). Unterhalb der Serienresonanz und oberhalb der Parallelresonanz ist eine derartige negative Phase mit einem Betrag ungleich 0° zu erwarten.

In der Fig. 7 ist eine Aufnahme aus dem Frequenzbereich zwischen Serien- und Parallelresonanz (Arbeitsbereich) dargestellt. Hierbei hat die Phase bei positivem Vorzeichen einen Wert von > 0°, was bedeutet, dass der Strom 16 der Spannung 15 vorauseilt.

Wenn über alle Frequenzen Signale gemäß Fig. 5 gemessen werden, liegt der Fall eines Kurzschlusses vor, wobei dann unabhängig von der gewählten Frequenz eine Phase von etwa 0° gemessen wird. Bei einer Frequenz, die unterhalb der Serienresonanzfrequenz oder oberhalb der Parallelresonanz des verwendeten Schwingkreises liegt, sollte bei funktionierendem Schwingkreis eigentlich eine negative Phase mit einem Betrag ungleich Null detektiert werden (vgl. Fig. 6); zwischen den Resonanzstellen dagegen eine positive Phase ungleich Null (vgl. Fig. 7)

Figur 6 zeigt dagegen den Fall eines gänzlich fehlenden Schwinggebildes, wenn unabhängig von der gewählten Frequenz über den Frequenzgang eine Phase kleiner 0° gemessen wird. Bei richtig angeschlossenem Schwinggebilde treten dagegen alle Messzustände gemäß den Figuren 5 bis 7 wenigstens ein Mal auf.

### Bezugszeichenliste

- 1: Transformator
- 2: Generator
- 2a: Generator-Ausgang
- 2b: Anpassnetzwerk
- 2c: Schwingkreis (elektrisch)
- 2d: Schwingkreis (elektro-mechanisch)
- 3: Messschaltung
- 4: Transformatorwicklung
- 4a: Hilfswicklung
- 5: Ferritkern
- 6: Induktivität
- 7: Schwinggebilde
- 8: Ultraschallwandler
- 8a: Ultraschallstrahler, -schwinger; Sonotrode
- 9: Endstufe
- 10: Kabel
- 11: Signalverarbeitungseinheit
- 12: Datenverarbeitungseinheit
- 13: Operationsverstärker
- 14: invertierter Schmitt-Trigger
- 15: Stromsignal
- 16: Spannungssignal

- A: Eingang Frequenz
- B1: Ausgang Phase Strom
- B2: Ausgang Phase Spannung
- C1-2: Kapazität
- D: Diode
- K: Knoten
- R1-6: Widerstand

- F-l: Verfahrensschritte

## Patentansprüche

1. Verfahren zum Bestimmen eines Arbeitsbereiches eines Ultraschall-Schwinggebildes (7), welches Ultraschall-Schwinggebilde (7) von einem Generator (2) über einen Ausgang (2a) mit elektrischer Energie versorgt und zu Ultraschallschwingungen angeregt wird, wobei zumindest Bestandteile des Ultraschall-Schwinggebildes (7), vorzugsweise ein darin enthaltener Ultraschallwandler (8), und Bestandteile des Generators (2), vorzugsweise ein ausgangsseitiges Anpassnetzwerk (2b), einen Schwingkreis (2c, 2d) bilden, und wobei dem Ausgang (2a) des Generators (2) eine Messschaltung (3) und eine Endstufe (9) vorgeschaltet werden, welche Endstufe (9) zur Anlegung von Signalen an den Schwingkreis (2c, 2d) zur Anregung des Ultraschall-Schwinggebildes (7) ausgebildet ist, und mittels welcher Messschaltung (3) zumindest die Phase, vorzugsweise Phase und Betrag, einer Impedanz des Schwingkreises (2c, 2d) gemessen werden, und zumindest die Phase, vorzugsweise Phase und Betrag, der Impedanz zum Bestimmen des Arbeitsbereichs ausgewertet wird, indem über die Messschaltung (3) eine Spannung (U) an den Schwingkreis (2c, 2d) angelegt wird,
**dadurch gekennzeichnet, dass** während des Anlegens der Spannung, U, über die Messschaltung (3) an den Schwingkreis (2c, 2d) keine Spannung über die Endstufe (9) an den Schwingkreis (2c, 2d) angelegt wird.

2. Verfahren nach Anspruch 1,
**dadurch gekennzeichnet,**
**dass** die Spannung (U) über eine induktive Ankopplung, insbesondere eine Induktivität oder Drossel, innerhalb des Generators (2) oder in elektrischer Wirkverbindung mit dem Generator (2) angelegt wird.

3. Verfahren nach Anspruch 1 oder 2, **dadurch gekennzeichnet, dass** die Spannung (U) über eine induktive, primärseitige oder sekundärseitige Ankopplung an einen Transformator (1) innerhalb des Generators (2) an den Schwingkreis angelegt wird, vorzugsweise über eine primärseitige Hilfswicklung (4a) des Generators (2).

4. Verfahren nach Anspruch 2 oder 3, **dadurch gekennzeichnet, dass** Betrag und/oder Phase der Impedanz über die induktive Ankopplung , vorzugsweise die primärseitige Hilfswicklung (4a) des Transformators (1), gemessen werden.

5. Verfahren nach einem der Ansprüche 1-4, **dadurch gekennzeichnet, dass** die Spannung (U) in der Größenordnung von 1-50 V, vorzugsweise 1-15 V, höchst vorzugsweise 5 V angelegt wird.

6. Verfahren nach einem der Ansprüche 1-5, **dadurch gekennzeichnet, dass** zum Bestimmen des Arbeitsbereichs die mittels der Messschaltung (3) gemessenen Signale an Signalausgängen (B1, B2) der Messschaltung (3) mittels einer Signalverarbeitungseinheit (11) abgegriffen werden.

7. Verfahren nach Anspruch 6, **dadurch gekennzeichnet, dass** die gemessenen Signale von der Signalverarbeitungseinheit (11) an eine Datenverarbeitungseinheit (12) gesendet werden, in welcher eine Auswertung der Signale anhand einer zu der Phase der Impedanz proportionalen Gleichspannung erfolgt.

8. Schaltungssystem umfassend eine Schaltungsanordnung zur Durchführung eines Verfahrens nach einem der vorangehenden Ansprüche und einen Generator (2), wobei die Schaltungsanordnung ein Ultraschall-Schwinggebilde (7) umfasst, wobei das Ultraschall-Schwinggebilde (7) an den Generator (2) angeschlossen ist und von dem Generator (2) über einen Ausgang (2a) mit elektrischer Energie versorgbar und zu Ultraschallschwingungen anregbar ist, wobei zumindest Bestandteile des Ultraschall-Schwinggebildes (7), vorzugsweise ein darin enthaltener Ultraschallwandler (8), und Bestandteile des Generators (2), vorzugsweise ein ausgangsseitiges Anpassnetzwerk (2b), einen Schwingkreis (2c, 2d) bilden, und wobei dem Ausgang (2a) des Generators (2) eine Messschaltung (3) und eine Endstufe (9) vorgeschaltet sind, welche Endstufe (9) zur Anlegung von Signalen an den Schwingkreis (2c, 2d) zur Anregung des Ultraschall-Schwinggebildes (7) ausgebildet ist, und wobei mittels der Messschaltung (3) zumindest die Phase, vorzugsweise Phase und Betrag, einer Impedanz des Schwingkreises (2c, 2d) messbar ist, und wobei die Schaltungsanordnung weiterhin dazu ausgebildet ist, zumindest die Phase, vorzugsweise Phase und Betrag, der Impedanz zwecks Bestimmung des Arbeitsbereichs auszuwerten, wobei über die Messschaltung (3) eine Spannung, U, an den Schwingkreis (2a, 2d) anlegbar ist, **dadurch gekennzeichnet, dass** die Schaltungsanordnung dazu ausgebildet ist, während des Anlegens der Spannung, über die Messschaltung (3) an den Schwingkreis (2c, 2d) keine Spannung über die Endstufe (9) an den Schwingkreis (2c, 2d) anzulegen.

9. Schaltungssystem nach Anspruch 8, **dadurch gekennzeichnet, dass** die Messschaltung (3) mit einem Transformator (1) oder einem induktiven Bauteil innerhalb des Generators (2) oder in elektrischer Wirkverbindung mit dem Generator (2) verbunden ist, vorzugsweise induktiv angekoppelt.

10. Schaltungssystem nach Anspruch 9, **dadurch gekennzeichnet, dass** der Transformator (1) primärseitig oder sekundärseitig eine induktive Ankopplung aufweist, vorzugsweise eine primärseitige Hilfswicklung (4a), die schaltungstechnisch zwischen Schwingkreis (2c, 2d) und Messschaltung (3) angeordnet ist.

11. Schaltungssystem nach Anspruch 10, **dadurch gekennzeichnet, dass** die Messschaltung (3) primärseitig und der Schwingkreis (2c, 2d) sekundärseitig bezüglich des Transformators (1) angeordnet ist.

12. Schaltungssystem nach einem der Ansprüche 8-11, **dadurch gekennzeichnet, dass** dem Schwingkreis (2c, 2d) eine Signalverarbeitungseinheit (11) zum Auslesen von durch die Messschaltung (3) gelieferten Signalverläufen der gemessenen Größen zugeordnet ist, welche Signalverarbeitungseinheit (11) vorzugsweise zum Erzeugen einer der Phase der Impedanz proportionalen Gleichspannung ausgebildet ist.

13. Schaltungssystem nach einem der Ansprüche 8-12, **dadurch gekennzeichnet, dass** dem Schwingkreis (2c, 2d) eine Datenverarbeitungseinheit (12) zur Auswertung der gemessenen Signalverläufe zugeordnet ist, welche Datenverarbeitungseinheit (12) dazu eingerichtet ist, anhand der gemessenen Signalverläufe den Arbeitsbereich zu erkennen und/oder anzuzeigen, vorzugsweise automatisch, höchst vorzugsweise zwecks Erzeugung eines Steuerungs- oder Regelungssignal für den Generator (2).

## Claims

1. Method for determining an operating range of an ultrasound oscillating structure (7), which ultrasound oscillating structure (7) is supplied with electrical energy from a generator (2) via an output (2a) and is excited to ultrasound oscillations, wherein at least components of the ultrasound oscillating structure (7), preferably an ultrasonic transducer (8) contained therein, and components of the generator (2), preferably an adjusting network (2b) on the output side, form an oscillating circuit (2c, 2d), and wherein a measurement circuit (3) and an output stage (9) are connected upstream of the output (2a) of the generator (2), which output stage (9) is configured to apply signals to the oscillating circuit (2c, 2d) to excite the ultrasound oscillating structure (7), and by means of which measuring circuit (3) at least the phase, preferably phase and magnitude, of an impedance of the oscillating circuit (2c, 2d) are measured, and at least the phase, preferably phase and magnitude, of the impedance are evaluated in order to determine the operating range by applying a voltage (U) to the oscillating circuit (2c, 2d) via the measuring circuit (3),
**characterised in that** during the application of the voltage, U, via the measuring circuit (3) to the oscillating circuit (2c, 2d), no voltage is applied via the output stage (9) to the oscillating circuit (2c, 2d).

2. Method according to claim 1,
**characterised in that**
the voltage (U) is applied via an inductive coupling, in particular an inductor or choke, within the generator (2) or in electrical operative connection with the generator (2).

3. Method according to claim 1 or 2, **characterised in that** the voltage (U) is applied to the oscillating circuit via an inductive, primary-side or secondary-side coupling to a transformer (1) within the generator (2), preferably via a primary-side auxiliary winding (4a) of the generator (2).

4. Method according to claim 2 or 3, **characterised in that** the magnitude and/or phase of the impedance is measured via the inductive coupling, preferably the primary-side auxiliary winding (4a) of the transformer (1).

5. Method according to any of claims 1-4, **characterised in that** the voltage (U) is applied in the order of 1-50 V, preferably 1-15 V, most preferably 5 V.

6. Method according to any of claims 1-5, **characterised in that** in order to determine the operating range, the signals measured by means of the measuring circuit (3) are tapped at signal outputs (B1, B2) of the measuring circuit (3) by means of a signal processing unit (11).

7. Method according to claim 6, **characterised in that** the measured signals are sent by the signal processing unit (11) to a data processing unit (12), in which an evaluation of the signals takes place based on a DC voltage proportional to the phase of the impedance.

8. Circuit system comprising a circuit arrangement for performing a method according to any of the preceding claims and a generator (2), wherein the circuit arrangement comprises an ultrasound oscillating structure (7), wherein the ultrasound oscillating structure (7) is connected to the generator (2) and can be supplied with electrical energy by the generator (2) via an output (2a) and can be excited to ultrasound oscillations, wherein at least components of the ultrasound oscillating structure (7), preferably an ultrasonic transducer (8) contained therein, and components of the generator (2), preferably an adjustment network (2b) on the output side, form an oscillating circuit (2c, 2d), and wherein a measuring circuit (3) and an output stage (9) are connected upstream of the output (2a) of the generator (2), which output stage (9) is designed to apply signals to the oscillating circuit (2c, 2d) to excite the ultrasound oscillating structure (7), and wherein by means of the measuring circuit (3) at least the phase, preferably phase and magnitude, of an impedance of the oscillating circuit (2c, 2d) can be measured, and wherein the circuit arrangement is further configured to evaluate at least the phase, preferably phase and magnitude of the impedance for the purpose of determining the operating range, wherein a voltage, U, can be applied to the oscillating circuit (2a, 2d) via the measuring circuit (3),
**characterised in that** the circuit arrangement is designed not to apply voltage to the oscillating circuit (2c, 2d) via the output stage (9) during the application of the voltage, U, to the oscillating circuit (2c, 2d) via the measuring circuit (3).

9. Circuit system according to claim 8, **characterised in that** the measuring circuit (3) is connected to a transformer (1) or an inductive component within the generator (2) or is in electrical operative connection with the generator (2), preferably inductively coupled.

10. Circuit system according to claim 9, **characterised in that** the transformer (1) has an inductive coupling on the primary side or secondary side, preferably a primary-side auxiliary winding (4a), which is arranged in terms of circuitry between the oscillating circuit (2c, 2d) and the measuring circuit (3).

11. Circuit system according to claim 10, **characterised in that** the measuring circuit (3) is arranged on the primary side and the oscillating circuit (2c, 2d) is arranged on the secondary side with respect to the transformer (1).

12. Circuit system according to any of claims 8-11, **characterised in that** the oscillating circuit (2c, 2d) is associated with a signal processing unit (11) for reading out signal characteristics of the measured quantities supplied by the measuring circuit (3), which signal processing unit (11) is preferably designed to generate a DC voltage proportional to the phase of the impedance.

13. Circuit system according to any of claims 8-12, **characterised in that** the oscillating circuit (2c, 2d) is assigned a data processing unit (12) for evaluating the measured signal characteristics, which data processing unit (12) is set up to recognise and/or display the operating range based on the measured signal characteristics, preferably automatically, most preferably for the purpose of generating a control or regulating signal for the generator (2).

## Revendications

1. Procédé permettant de définir une zone de travail d'un dispositif générateur d'ultrasons (7), lequel dispositif générateur d'ultrasons (7) est alimenté en énergie électrique par un générateur (2) par l'intermédiaire d'une sortie (2a) et est excité de manière à générer des ultrasons, dans lequel au moins des éléments constitutifs du dispositif générateur d'ultrasons (7), de manière préférée un transducteur d'ultrasons (8) contenu en son sein, et des éléments constitutifs du générateur (2), de manière préférée un réseau d'adaptation (2b) situé côté sortie, forment un circuit oscillant (2c, 2d ), et dans lequel un circuit de mesure (3) et un étage final (9) sont montés en amont de la sortie (2a) du générateur (2), lequel étage final (9) est conçu pour appliquer des signaux au circuit oscillant (2c, 2d) afin d'exciter le dispositif générateur d'ultrasons (7), et au moins la phase, de manière préférée la phase et la quantité, d'une impédance du circuit oscillant (2c, 2d) sont mesurées au moyen dudit circuit de mesure (3), et au moins la phase, de manière préférée la phase et la quantité, de l'impédance sont évaluées afin de définir la zone de travail en appliquant une tension (U) au circuit oscillant (2c, 2d) par l'intermédiaire du circuit de mesure (3),
**caractérisé en ce qu'**aucune tension n'est appliquée au circuit oscillant (2c, 2d) par l'intermédiaire de l'étage final (9) pendant l'application de la tension (U) au circuit oscillant (2c, 2d) par l'intermédiaire du circuit de mesure (3).

2. Procédé selon la revendication 1,
caractérisé en ce
la tension (U) est appliquée par l'intermédiaire d'un couplage inductif, en particulier d'une inductance ou d'un inducteur, à l'intérieur du générateur (2) ou en liaison électrique fonctionnelle avec le générateur (2).

3. Procédé selon la revendication 1 ou 2, **caractérisé en ce que** la tension (U) est appliquée au circuit oscillant par l'intermédiaire d'un couplage inductif, situé côté primaire ou côté secondaire, au niveau d'un transformateur (1) à l'intérieur du générateur (2), de manière préférée par l'intermédiaire d'un enroulement auxiliaire (4a), situé côté primaire, du générateur (2).

4. Procédé selon la revendication 2 ou 3, **caractérisé en ce que** la quantité et/ou la phase de l'impédance sont mesurées par l'intermédiaire du couplage inductif, de manière préférée de l'enroulement auxiliaire (4a), situé côté primaire, du transformateur (1).

5. Procédé selon l'une quelconque des revendications 1 à 4, **caractérisé en ce que** la tension (U) est appliquée selon un ordre de grandeur compris entre 1 et 50 V, de manière préférée compris entre 1 et 15 V, de manière préférée égal à 5 V.

6. Procédé selon l'une quelconque des revendications 1 à 5, **caractérisé en ce que** les signaux mesurés au moyen du circuit de mesure (3) sont prélevés au niveau des sorties de signal (B1, B2) du circuit de mesure (3) au moyen d'une unité de traitement de signal (11) afin de définir la zone de travail.

7. Procédé selon la revendication 6, **caractérisé en ce que** les signaux mesurés sont envoyés de l'unité de traitement de signal (11) vers une unité de traitement de données (12) au sein de laquelle les signaux sont évalués à l'aide d'une tension continue proportionnelle à la phase de l'impédance.

8. Système de circuit comprenant un agencement de circuit permettant de mettre en œuvre un procédé selon l'une quelconque des revendications précédentes et un générateur (2), dans lequel l'agencement de circuit comprend un dispositif générateur d'ultrasons (7), dans lequel le dispositif générateur d'ultrasons (7) est raccordé au générateur (2) et peut être alimenté en énergie électrique par le générateur (2) par l'intermédiaire d'une sortie (2a) et peut être excité afin de générer des ultrasons, dans lequel au moins des éléments constitutifs du dispositif générateur d'ultrasons (7), de manière préférée un transducteur d'ultrasons (8) contenu en son sein, et des éléments constitutifs du générateur (2), de manière préférée un réseau d'adaptation (2b) situé côté sortie, forment un circuit oscillant (2c, 2d ), et dans lequel un circuit de mesure (3) et un étage final (9) sont montés en amont de la sortie (2a) du générateur (2), lequel étage final (9) est conçu pour appliquer des signaux au circuit oscillant (2c, 2d) afin d'exciter le dispositif générateur d'ultrasons (7), et dans lequel au moins la phase, de manière préférée la phase et la quantité, d'une impédance du circuit oscillant (2c, 2d) peut être mesurée au moyen du circuit de mesure (3), et dans lequel l'agencement de circuit est en outre conçu pour évaluer au moins la phase, de manière préférée la phase et la quantité, de l'impédance afin de définir la zone de travail, dans lequel une tension U peut être appliquée au circuit oscillant (2a, 2d) par l'intermédiaire du circuit de mesure (3),
**caractérisé en ce que** l'agencement de circuit est conçu pour n'appliquer aucune tension au circuit oscillant (2c, 2d) par l'intermédiaire de l'étage final (9) pendant l'application de la tension (U) au circuit oscillant (2c, 2d) par l'intermédiaire du circuit de mesure (3).

9. Système de circuit selon la revendication 8, **caractérisé en ce que** le circuit de mesure (3) est relié à un transformateur (1) ou à un élément inductif à l'intérieur du générateur (2) ou est en liaison électrique fonctionnelle avec le générateur (2), de manière préférée avec un couplage inductif.

10. Système de circuit selon la revendication 9, **caractérisé en ce que** le transformateur (1) présente un couplage inductif côté primaire ou côté secondaire, de manière préférée un enroulement auxiliaire (4a) situé côté primaire et agencé entre le circuit oscillant (2c, 2d) et le circuit de mesure (3) en termes de circuit.

11. Système de circuit selon la revendication 10, **caractérisé en ce que** le circuit de mesure (3) est agencé du côté primaire et le circuit oscillant (2c, 2d) est agencé du côté secondaire, par rapport au transformateur (1).

12. Système de circuit selon l'une quelconque des revendications 8 à 11, **caractérisé en ce qu'**une unité de traitement de signal (11) permettant de lire des courbes de signal, fournies grâce au circuit de mesure (3), des grandeurs mesurées est associée au circuit oscillant (2c, 2d), laquelle unité de traitement de signal (11) est conçue de manière préférée pour générer une tension continue proportionnelle à la phase de l'impédance.

13. Système de circuit selon l'une quelconque des revendications 8 à 12, **caractérisé en ce qu'**une unité de traitement de données (12) permettant d'évaluer des courbes de signal mesurées est associée au circuit oscillant (2c, 2d), laquelle unité de traitement de données (12) est conçue pour identifier et/ou indiquer la zone de travail à l'aide des courbes de signal mesurées, de manière préférée de manière automatique, de la manière la plus préférée afin de générer un signal de commande ou de régulation destiné au générateur (2).
